# EUROPÄISCHE PATENTSCHRIFT

(11) **EP 1 127 272 B1**
(45) Veröffentlichungstag und Bekanntmachung des Hinweises auf die Patenterteilung: **24.09.2003**
(21) Anmeldenummer: 99957945.1
(22) Anmeldetag: 28.10.1999
(51) Int. Cl.: G01N 29/02, H03H 9/02

(54) **Oberflächenwellensensor**
Surface wave sensor
Capteur à ondes de surface

(30) Priorität: 04.11.1998 DE 19850802
(43) Veröffentlichungstag der Anmeldung: 29.08.2001
(73) Patentinhaber: ROBERT BOSCH GMBH, 70442 Stuttgart (DE)
(72) Erfinder: MOELLENDORF, Manfred, D-71229 Leonberg (DE); EISENSCHMID, Heinz, D-71254 Hirschlanden (DE); HERRMANN, Falk, D-71229 Leonberg (DE)
(86) Internationale Anmeldenummer: DE9903457
(87) Internationale Veröffentlichungsnummer: WO00026660

(56) Entgegenhaltungen:
- EP-A- 0 392 879
- US-A- 5 440 188
- US-A- 5 741 961
- DU J ET AL: "A STUDY OF LOVE-WAVE ACOUSTIC SENSORS" SENSORS AND ACTUATORS A,CH,ELSEVIER SEQUOIA S.A., LAUSANNE, Bd. A56, Nr. 3, 1. September 1996 (1996-09-01), Seiten 211-219, XP000640390 ISSN: 0924-4247 in der Anmeldung erwähnt

## Beschreibung

### Stand der Technik

Die Erfindung betrifft eine Sensoranordnung zur Ermittlung der physikalischen Eigenschaften von Flüssigkeiten und nach dem Oberbegriff des Hauptanspruchs.

Es werden beispielsweise Sensoranordnungen mit sog. akustischen SAW- oder Oberflächenwellenbauelementen (SAW = Surface Acoustic Wave) als Sensoren für verschiedenste physikalische Größen, insbesondere in Flüssigkeiten, angewandt. Einen wichtigen Bereich bildet hierbei die Messung elektrischer Größen, wie die Dielektrizitätskonstante und/oder die Leitfähigkeit, die Messung mechanischer Größen, wie z.B. die Dichte und/oder die Viskosität und die Untersuchung chemischer Eigenschaften, wie z.B. das Vorhandensein spezieller Substanzen in Flüssigkeiten.

Bei einer bekannten Sensoranordnung wird von einem Messprinzip ausgegangen, das beispielsweise in dem Aufsatz "A study of Love-wave acoustic sensors", J.Du, G.L.Hardling, P.R.Ogilvy und M.Lake in der Fachzeitschrift Sensors and Actuators A56(1996), Seiten 211 bis 219 beschrieben ist. Mit dem hier beschriebenen Messaufbau ist ein Sensor realisiert worden, bei dem mit horizontal polarisierten akustischen Scherwellen gearbeitet wird, sog. Leckwellen bzw. Surface Skimming Bulk Wave (SSBW-Wellen) oder Love-Wellen. Diese akustischen Wellenmoden werden mit sogenannten, für sich auch aus dem zuvor erwähnten Stand der Technik bekannten, Interdigitaltransducern erzeugt und auch detektiert, so dass aus dem Ausbreitungsverhalten auf einer Ausbreitungs- oder Messstrecke das gewünschte Sensorsignal gewonnen werden kann.

In Abhängigkeit von dem erforderlichen Messaufbau werden unterschiedliche Materialien und Anordnungen für die Sensorelemente verwendet, z.B. ein bestimmtes Substratmaterial für die Sensorelemente, eine vorgegebene Wellenausbreitungsrichtung, eventuell auch ein spezieller Schichtaufbau auf dem Substratmaterial und eine bestimmte Anordnung der als elektro-akustische Wandler aufgebauten Sensorelemente. Hierbei treten eine oder mehrere der zuvor genannten, für sich bekannten akustischen Wellenmoden auf, die sich hinsichtlich einer möglichen Messempfindlichkeit, Ausbreitungsgeschwindigkeit, einem akustoelektrischen Koppelfaktor und einer Anfälligkeit gegenüber Quereffekten usw. unterscheiden und damit die Eignung eines speziellen Sensortyps für eine spezifische Messaufgabe bestimmen.

Bei den oben beschriebenen, aus dem Stand der Technik bekannten akustischen Wellenmoden handelt es sich, wie erwähnt, um horizontal polarisierte akustische Scherwellen, bei denen eine sich entlang der Oberfläche des Substrats, auf dem sich die elektro-akustischen Wandler befinden, ausbreitende Welle genutzt wird.

Neben der Messempfindlichkeit beim Einsatz von SAW-Bauelementen als Sensoren insbesondere zur Flüssigkeitsuntersuchung ist insbesondere der Einfluss der Temperatur auf das Messergebnis von Bedeutung, z.B. beim Einsatz in flüssigen Medien, wie sie im Kraftfahrzeugbereich angewendet werden (z.B. Öle, Kraftstoffe, Bremsflüssigkeit usw.) tritt dabei eine relativ großer, das Messergebnis beeinflussender Temperaturbereich zwischen -40°C und +150°C auf.

### Vorteile der Erfindung

Die eingangs erwähnte gattungsgemäße Sensoranordnung zur Ermittlung der physikalischen Eigenschaften einer Flüssigkeit ist gemäß der Erfindung mit den kennzeichnenden Merkmalen des Hauptanspruchs weitergebildet.

Die erfindungsgemäße Sensoranordnung weist als Substrat einen Y-gedrehten Quarzschnitt auf und besitzt über dem Substrat eine Wellenleiterschicht, wobei die Y-Drehung des Quarzschnittes und das Material der Wellenleiterschicht so gewählt sind, dass sich eine weitgehende Temperaturkompensation im Bereich der Temperatur der Flüssigkeit ergibt. Bei den eingangs erwähnten Wellenmoden der akustischen Oberflächenwelle kann der Effekt ausgenutzt werden, dass die akustische Wellenleitung durch eine auf dem Substrat befindliche akustisch langsame Wellenleiterschicht so beeinflusst wird, dass horizontal polarisierte oberflächennahe Scherwellen (SSB-Wellen) oder Leckwellen (Leakywaves) in Oberflächenmoden konvertiert werden. Somit wird die Messempfindlichkeit gegenüber viskosen, akusto-elektrischen oder gravimetrischen Wechselwirkungen mit der umgebenden Flüssigkeit gezielt erhöht bzw. exakt eingestellt.

Eine Voraussetzung für einen ausgeprägten Wellenleitereffekt ist ein möglichst großer Unterschied zwischen den Scherwellengeschwindigkeiten von Substrat und Wellenleiterschicht. Bei z.B. in der Filtertechnik genutzten SAW-Bauelementen werden beispielsweise um 42,75° um die kristallographische X-Achse gedrehte sog. ST-Schnitte von α-Quarzen genutzt. Auf diesem Quarzschnitt können mit Hilfe von aus dem eingangs genannten Stand der Technik bekannten Interdigitaltransducern SSB-Wellen entlang der gedrehten Z-Ausbreitungsrichtung angeregt werden. Unter Ausnutzung des obengenannten Effektes der akustischen Wellenleitung durch akustisch langsame dielektrische Schichten können diese Moden in Love-Moden konvertiert werden.

Der Temperaturkoeffizient der Love-Moden-Wellen in der eingangs als Stand der Technik genannten Messanordnung liegt bei ca. +30 ppm/K. Da die für Sensoranwendungen ohne Temperaturstabilisierung zu erwartenden Frequenzschwankungen hiermit in der Größenordnung der Meßeffekte liegen, wird gemäß der Erfindung der Temperaturkoeffizient bei der Arbeitstemperatur der Flüssigkeit um mindestens eine Größenordnung reduziert.

Bei einer ersten vorteilhaften Ausführungsform wird als Substrat ein Y-gedrehter Quarzschnitt mit Drehwinkeln zwischen 25° und 36°, und als Wellenleiterschicht eine SiO2-Schicht verwendet. Besonders geeignet sind diese Quarzschnitte mit Drehwinkeln zwischen 25° und 36°, da mit ihnen in Verbindung mit SiO2-Schichten typischer Dikke (0,01 bis 0,25 akustische Wellenlängen) temperaturkompensierte Systeme mit Arbeitstemperaturen zwischen -40°C und +150°C erstellt werden können. Außerdem weisen die SSB-Wellen dieser Quarzschnitte die für Love-Mode-Sensoren notwendigen hohen Phasengeschwindigkeiten und Koppelfaktoren auf.

Bei einer zweiten Ausführungsform wird als Substrat ein Y-gedrehter Quarzschnitt mit Drehwinkeln zwischen 40° und 60° und als Wellenleiterschicht eine Schicht, vorzugsweise eine Polymerschicht, mit einem negativen Temperaturkoeffizienten verwendet. Wellenleiterschichten mit einem negativen Temperaturkoeffezienten, z.B. Polymere aus PMMA, BCB, Ormocere oder Spin-On-Glass, führen in Verbindung mit einem Y-gedrehten Quarzschnitt zu einer parabolischen Temperaturabhängigkeit der entstehenden Love-Mode-Welle und somit zu einer in Richtung niedriger Temperaturen verschobenen sog. Turnover-Temperatur.

Dieser Effekt kann somit wie bei der ersten Ausführungsform zur Erzeugung eines temperaturkompensierten Systems mit gleichzeitig guten Sensoreigenschaften genutzt werden. Für jeden dieser Quarzschnitte existiert bei gegebenem Wellenleitermaterial genau eine Schichtdicke, bei der das entstehende Love-Mode-Bauteil bei der vorgesehenen Arbeitstemperatur in erster Ordnung temperaturkompensiert ist.

Bei einer dritten Ausführungsform wird als Substrat ein Y-gedrehter Quarzschnitt, insbesondere mit einem Drehwinkel von ca. 48° (+/-1°) , und als Wellenleiterschicht eine z.B. Polymerschicht mit einem näherungsweise linearen negativen Temperaturkoeffizienten verwendet. Dieser Quarzschnitt des Substrats weist einen gegen Null gehenden quadratischen Temperaturkoeffizienten auf, so dass in Verbindung mit einer Schicht mit linearem negativem Temperaturkoeffizienten bei einer Wahl der richtigen Schichtdicke eine in guter Näherung in erster und zweiter Ordnung temperaturkompensierte Sensoranordnung erstellt werden kann. Weiterhin zeigen diese Anordnungen bei den zur Temperaturkompensation erforderlichen Schichtdicken eine sehr hohe Empfindlichkeiten gegenüber viskosen und gravimetrischen Wechselwirkungen, so dass sie besonders gut für einen Sensoreinsatz geeignet sind.

Bei einer besonders vorteilhaften Anwendung wird die Sensoranordnung in einem Kraftfahrzeug zur Bestimmung der Qualität des Motoröls oder anderer Betriebsflüssigkeiten eingesetzt, wobei das Substrat direkt in das zu messende Öl eintauchbar ist.

Diese und weitere Merkmale von bevorzugten Weiterbildungen der Erfindung gehen außer aus den Ansprüchen, einschließlich der rückbezogenen Unteransprüche, auch aus der Beschreibung und den Zeichnungen hervor, wobei die einzelnen Merkmale jeweils für sich allein oder zu mehreren in Form von Unterkombinationen bei der Ausführungsform der Erfindung und auf anderen Gebieten verwirklicht sein und vorteilhafte sowie für sich schutzfähige Ausführungen darstellen können, für die hier Schutz beansprucht wird.

### Zeichnung

Ein Ausführungsbeispiel der erfindungsgemäßen Sensoranordnung wird anhand der Zeichnung erläutert. Es zeigen:
Figur 1 eine schematische Ansicht einer Sensoranordnung zur Ermittlung der Dichte und der Viskosität einer durch die Sensoranordnung strömenden Flüssigkeit;
Figur 2 einen Detailschnitt durch ein Substrat mit einem Interdigitaltransducer als elektro-akustischem Wandler und einer darüber liegenden Wellenleiterschicht;
Figur 3 ein Diagramm der Temperaturgänge von SSB-Wellen auf verschiedenen Quarzschnitten des Substrats und
Figur 4 ein Diagramm der sog. Turnover-Temperatur von Love-Moden-Wellen in Abhängigkeit von der Schichtdicke der Wellenleiterschicht.

### Beschreibung des Ausführungsbeispiels

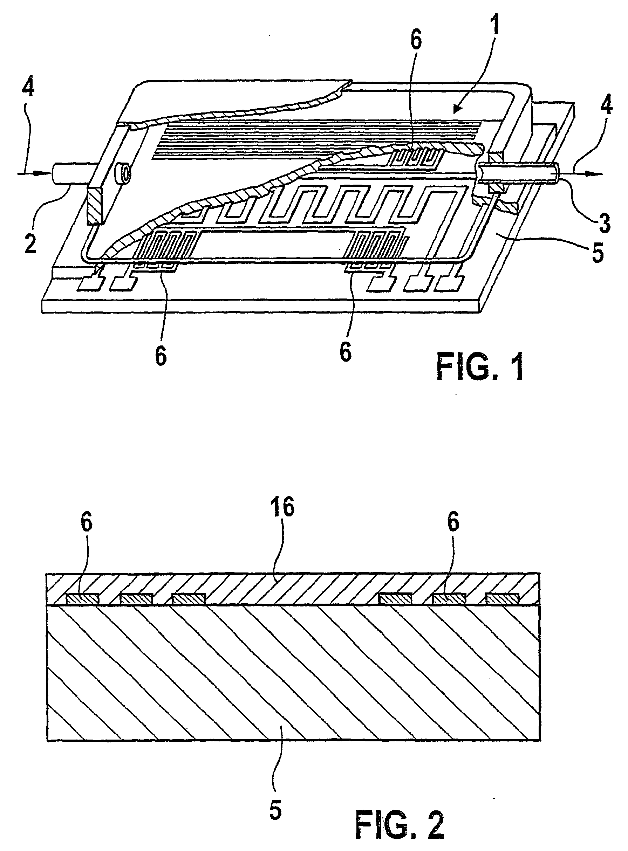

Aus Figur 1 ist beispielhaft zur Anwendung der Erfindung eine Sensoranordnung 1 in einer aufgeschnittenen Prinzipdarstellung gezeigt, durch die eine Messflüssigkeit zur Bestimmung ihrer Dichte und ihrer Viskosität von einem Eingang 2 zu einem Ausgang 3 gemäß Pfeil 4 fließt. Hauptbestandteil der vorgeschlagenen Sensoranordnung 1 ist ein einseitig poliertes Substrat 5 aus einem piezoelektrischen Werkstoff, in dem horizontal polarisierte akustische Schermoden von Sensorgrundelementen anregbar und ausbreitungsfähig sind. Als Substratwerkstoffe sind Y-rotierte Quarzschnitte, einige Lithiumniobat- und Lithiumtantalatschnitte sowie entsprechend gepolte piezoelektrische Keramiken geeignet.

Auf der polierten Oberfläche des Substrats 5 befindet sich eine Anordnung aus metallischen Interdigitaltransducern (IDT) 6. Diese Interdigitaltransducer 6 dienen zur Anregung und Detektion der akustischen Oberflächenwellen.

Auf dem Substrat 5 ist nach der Figur 1 und der Detaildarstellung nach Figur 2 oberhalb der Sensorgrundelemente mit den IDT 6 eine akustische Wellenleiterschicht 16 angeordnet, die z.B. aus einem Ormocer, aus einer Siliziumverbindung oder einem Polymer bestehen kann, so dass aus dem allgemeinen Schermode (Leckwelle oder SSBW) der akustischen Welle ein sog. Wellenleitermode (hier eine Love-Mode-Welle) wird.

Durch eine geeignete Wahl der Werkstoffe des Substrats 5 und der Wellenleiterschicht 16 nach den Figuren 1 und 2 kann eine optimale Temperaturkompensation in der Sensoranordnung erreicht werden, insbesondere sollte das Temperaturverhalten der akustischen Wellenmoden bei einer Betriebstemperatur, z.B. bei ca. 25C° oder einer anderen Temperatur im Bereich von -40°C und +150°C, optimiert werden können. Das Temperaturverhalten dieser Wellenmoden weist einen parabolischen Verlauf auf, wobei es ein Ziel der Werkstoffauswahl sein soll, den Scheitelpunkt der Temperaturkurve (Turnover-Temperatur) auf die Betriebstemperatur zu legen, da somit die Temperaturveränderung den geringsten Einfluss auf die Schwingfrequenz der Anordnungen haben. Der Temperaturkoeffizient einer Love-Mode-Welle kann hierbei durch eine Überlagerung der Temperaturkoeffizienten des Substrats 5 und der Wellenleiterschicht 16 beschrieben werden. Bei richtiger Auswahl von Substrat- und Schichtmaterial kann so das Temperaturverhalten optimiert werden.

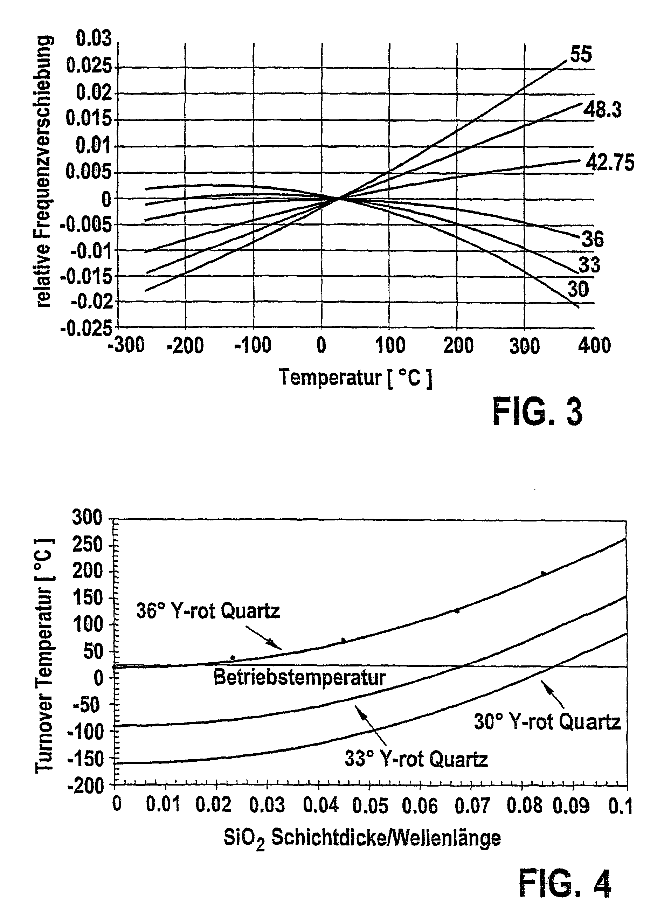

Das Temperaturverhalten der erwähnten Wellenmoden ist für verschiedene Y-gedrehte Quarzschnitte (im Bereich von 30° bis 55°) in Figur 3 dargestellt, hier ausgedrückt durch die auf die Betriebstemperatur, meist 25°C, normierte Frequenzverschiebung; das Temperaturverhalten weist einen parabolischen Verlauf auf.

Beispielsweise kann als Substrat 5 ein Y-gedrehter Quarzschnitt, insbesondere mit Drehwinkeln zwischen 25° und 36° und als Wellenleiterschicht 16 eine SiO2-Schicht, deren Dicke entsprechend der geforderten Sensitivität gewählt ist, verwendet werden. Hier ergibt sich im Bereich einer Arbeitstemperatur von -40° bis +150° ein in erster Ordnung temperaturkompensiertes System. Eine SiO2-Schicht weist im Gegensatz zu vielen anderen Werkstoffen einen positiven, annähernd linearen Temperaturkoeffizienten auf. Wird eine solche Schicht auf einem Y-gedrehten Quarzschnitt zur Erzeugung von Love-Mode-Wellen verwendet, ist der Temperaturgang der entstehenden Moden wie der der zugrundeliegenden SSB-Welle parabolisch, jedoch mit einer in Richtung höherer Temperaturen verschobenen Turnover-Temperatur. Wie stark die Turnover-Temperatur verschoben wird hängt von der auf die akustische Wellenlänge bezogenen Schichtdicke ab. Dieser Zusammenhang ist für die Quarzschnitte mit einer Y-Rotation von 30°, von 33° und von 36° in Figur 4 dargestellt.

Wird ein Quarzschnitt verwendet, bei dem die Turnover-Temperatur der SSB-Welle deutlich unterhalb der Betriebstemperatur liegt, kann in Verbindung mit einer SiO2-Schicht die Turnover-Temperatur der Love-Mode-Welle auf die Betriebstemperatur verschoben werden, was einer Kompensation des Temperaturkoeffizienten erster Ordnung entspricht. Das Maß der Turnover-Temperatur-Verschiebung hängt, wie aus der Figur 4 ersichtlich, von der normierten Wellenleiterschichtdicke ab und diese bestimmt wiederum die Sensitivität des Love-Mode-Sensors. Für jede durch die spezielle Sensorfunktion bestimmte Wellenleiterschichtdicke und Arbeitstemperatur kann ein Quarzschnitt gefunden werden, der zu einem temperaturkompensierten Sensorelement führt.

Bei einem anderen Beispiel kann als Substrat 5 ein Y-gedrehter Quarzschnitt, insbesondere mit Drehwinkeln zwischen 40° und 60° und als Wellenleiterschicht 16 eine Schicht mit negativem Temperaturkoeffizienten, deren Dikke entsprechend der geforderten Sensitivität gewählt ist, verwendet werden. Auch hier ergibt sich im Bereich einer Arbeitstemperatur von -40° bis +150° ein in erster Ordnung temperaturkompensiertes System.

Bei einem dritten Beispiel kann als Substrat 5 ein Y-gedrehter Quarzschnitt mit einem Drehwinkel von 48° +/-1° und als Wellenleiterschicht 16 eine Schicht mit näherungsweise linearem, negativen Temperaturkoeffizienten, deren Dicke entsprechend der geforderten Sensitivität gewählt ist, verwendet werden. Hier ergibt sich im Bereich einer Arbeitstemperatur von -40° bis +150° ein in erster und zweiter Ordnung temperaturkompensiertes System.

## Patentansprüche

1. Sensoranordnung zur Ermittlung von physikalischen Eigenschaften einer Flüssigkeit mit einem Substrat (5) mit darauf aufgebrachten elektroakustischen Wandlern (6), die mit der Flüssigkeit in Wirkverbindung stehen, und mit einer über dem Substrat und den Wandlern angeordneten Wellenleiterschicht (16), wobei die Wandler (6) zur Erzeugung und Detektion von als Love-Wellen ausgebildeten akustischen Oberflächenwellen dienen und wobei mit Hilfe der Wandler (6) das Ausbreitungsverhalten der Love-Wellen entlang einer Meßstrecke als Maß für die physikalischen Eigenschaften ermittelbar ist, **dadurch gekennzeichnet, daß** als Substrat (5) ein Y-gedrehter Quarzschnitt verwendet wird, wobei das Maß der Y-Drehung des Quarzschnittes und das Material der Wellenleiterschicht (16) so gewählt sind, daß sich eine weitgehende Temperaturkompensation der verwendeten Love-Wellen im Bereich der Temperatur der zu untersuchenden Flüssigkeit ergibt.

2. Sensoranordnung nach Anspruch 1, **dadurch gekennzeichnet, dass**
- als Substrat (5) ein Y gedrehter Quarzschnitt mit einem Drehwinkel zwischen 25° und 36° und als Wellenleiterschicht (16) eine SiO2-Schicht verwendet wird.

3. Sensoranordnung nach Anspruch 1, **dadurch gekennzeichnet, dass**
- als Substrat (5) ein Y-gedrehter Quarzschnitt mit einem Drehwinkel zwischen 40° und 60° und als Wellenleiterschicht (16) eine Schicht mit einem negativen Temperaturkoeffizienten verwendet wird.

4. Sensoranordnung nach Anspruch 1, **dadurch gekennzeichnet, dass**
- als Substrat (5) ein Y-gedrehter Quarzschnitt mit einem Drehwinkel von ca. 48° und als Wellenleiterschicht (16) eine Schicht mit einem näherungsweise linearen negativen Temperaturkoeffizienten verwendet wird.

5. Sensoranordnung nach Anspruch 3 oder 4, **dadurch gekennzeichnet, dass**
- die Wellenleiterschicht (16) eine Polymerschicht ist.

6. Sensoranordnung nach einem der vorhergehenden Ansprüche, **dadurch gekennzeichnet, dass**
- die Sensoranordnung in einem Kraftfahrzeug zur Bestimmung der Qualität des Motoröls oder anderer Betriebsflüssigkeiten einsetzbar ist, wobei das Substrat (5) direkt in das zu messende Öl eintauchbar ist.

## Claims

1. Sensor arrangement for ascertaining physical properties of a liquid, with a substrate (5) with electroacoustic transducers (6) applied to the said substrate and in operative connection with the liquid, and with a waveguide layer (16) which is arranged over the substrate and the transducers, the transducers (6) serving for generating and detecting surface acoustic waves formed as Love waves and the propagation behaviour of the Love waves being ascertainable with the aid of the transducers (6) along a measuring path as a measure of the physical properties, **characterized in that** a Y-rotated quartz slice is used as the substrate (5), the degree of Y rotation of the quartz slice and the material of the waveguide layer (16) being chosen such that an extensive temperature compensation of the Love waves used is obtained in the range of the temperature of the liquid to be investigated.

2. Sensor arrangement according to Claim 1, **characterized in that** a Y-rotated quartz slice with an angle of rotation of between 25° and 36° is used as the substrate (5) and an SiO2 layer is used as the waveguide layer (16).

3. Sensor arrangement according to Claim 1, **characterized in that** a Y-rotated quartz slice with an angle of rotation of between 40° and 60° is used as the substrate (5) and a layer with a negative temperature coefficient is used as the waveguide layer (16).

4. Sensor arrangement according to Claim 1, **characterized in that** a Y-rotated quartz slice with an angle of rotation of about 48° is used as the substrate (5) and a layer with an approximately linear negative temperature coefficient is used as the waveguide layer (16).

5. Sensor arrangement according to Claim 3 or 4, **characterized in that** the waveguide layer (16) is a polymer layer.

6. Sensor arrangement according to one of the preceding claims, **characterized in that** the sensor arrangement can be used in a motor vehicle for determining the quality of the engine oil or other operating liquids, the substrate (5) being able to be dipped directly into the oil to be measured.

## Revendications

1. Dispositif de capteur pour déterminer des propriétés physiques d'un liquide, comportant des convertisseurs (6) électroacoustiques appliqués sur un substrat (5) en coopération avec le liquide, et une couche guide d'ondes (16) sur le substrat et les convertisseurs, les convertisseurs (6) générant et détectant des ondes de surface acoustiques en forme d'ondes Love, et en déterminant à l'aide des convertisseurs (6) le comportement en développement des ondes Love suivant un chemin de mesure comme mesure des propriétés physiques,
**caractérisé en ce que**
le substrat (5) est une coupe de quartz à rotation Y et
la mesure de la rotation Y de la coupe de quartz et la matière de la couche de guide d'ondes (16) sont choisies pour obtenir une compensation en température poussée des ondes Love, utilisées, dans la plage de températures du liquide examiné.

2. Dispositif de capteur selon la revendication 1,
**caractérisé en ce que**
le substrat (5) est une coupe de quartz à rotation Y avec un angle de rotation compris entre 25° et 36° et la couche guide d'ondes (16) est une couche de SiO2.

3. Dispositif de capteur selon la revendication 1,
**caractérisé en ce que**
le substrat (5) est une coupe de quartz à rotation Y avec un angle de rotation compris entre 40° et 60° et la couche guide d'ondes (16) est une couche avec un coefficient de température négatif.

4. Dispositif de capteur selon la revendication 1,
**caractérisé en ce que**
le substrat (5) est une coupe de quartz à rotation Y avec un angle de rotation d'environ 48° et comme couche guide d'ondes (16) on utilise une couche avec un coefficient de température négatif sensiblement linéaire.

5. Dispositif de capteur selon la revendication 3 ou 4,
**caractérisé en ce que**
la couche guide d'ondes (16) est une couche de polymère.

6. Dispositif de capteur selon l'une des revendications précédentes,
**caractérisé en ce que**
le dispositif de capteur est appliqué à un véhicule automobile pour déterminer la qualité de l'huile du moteur et celle d'autres liquides de fonctionnement, le substrat (5) étant immergé directement dans le liquide à mesurer.
